(19) Europäisches Patentamt / European Patent Office / Office européen des brevets

(11) **EP 1 878 693 B1**

(12) **FASCICULE DE BREVET EUROPEEN**

(45) Date de publication et mention
de la délivrance du brevet:
**02.09.2009 Bulletin 2009/36**

(51) Int Cl.:
***B81C 1/00*** *(2006.01)*

(21) Numéro de dépôt: **07112282.4**

(22) Date de dépôt: **11.07.2007**

(54) **MICROCOMPOSANT ENCAPSULE EQUIPE D'AU MOINS UN GETTER**

Gekapseltes Mikrobauteil mit mindestens einem Getter

Encapsulated microcomponent equipped with at least one getter

(84) Etats contractants désignés:
**DE FR GB IT**

(30) Priorité: **13.07.2006 FR 0652978**

(43) Date de publication de la demande:
**16.01.2008 Bulletin 2008/03**

(73) Titulaire: **Commissariat à l'Energie Atomique
75015 Paris (FR)**

(72) Inventeurs:
• **Pornin, Jean-Louis
38920, CROLLES (FR)**
• **Gillot, Charlotte
38500, VOIRON (FR)**
• **Baleras, Francois
38450 SAINT GEORGES DE COMMIERS (FR)**

(74) Mandataire: **Poulin, Gérard
Brevatome
3, rue du Docteur Lancereaux
75008 Paris (FR)**

(56) Documents cités:
| | |
|---|---|
| WO-A-20/04065289 | WO-A1-02/27058 |
| WO-A2-20/05047558 | FR-A1- 2 864 341 |
| US-A1- 2003 183 916 | US-A1- 2005 017 313 |
| US-A1- 2005 250 253 | |

**Description**

**DOMAINE TECHNIQUE**

La présente invention concerne un microcomposant encapsulé comportant une cavité étanche délimitée par un capot, cette cavité étant dotée d'au moins un getter (aussi appelé fixateur de gaz) destiné à piéger des gaz susceptibles de se trouver dans la cavité.

L'encapsulation des microsystèmes électromécaniques connus sous la dénomination de MEMS est aujourd'hui une clef de leur développement. D'autres microcomposants électroniques, optiques, optoélectroniques peuvent aussi être concernés par cette encapsulation. Par la suite, on a employé le terme microcomposant qui englobe ici un microsystème, un microcomposant électronique, optique ou optoélectronique. Les circuits intégrés sont englobés dans la dénomination de microcomposant électronique, optique ou optoélectronique.

De plus en plus de ces microcomposants fonctionnent sous vide ou sous pression réduite car la présence de gaz peut nuire à un fonctionnement correct. C'est notamment le cas pour les microcomposants qui présentent des parties mobiles. La qualité du fonctionnement est liée à la maîtrise du vide obtenu lors de l'encapsulation en terme de pression, de nature de gaz résiduels ou relargués mais également en terme de durée de vie.

On est obligé de placer, à proximité du microcomposant, un getter prenant la forme soit d'un élément discret soit la forme d'un film qui va contribuer à réduire ou à stabiliser la pression dans la cavité en absorbant des gaz résiduels émis par différentes parties présentes dans la cavité, et des molécules qui pourraient diffuser à travers le capot au cours du temps.

**ÉTAT DE LA TECHNIQUE ANTÉRIEURE**

Actuellement les solutions qui existent dans ce domaine sont de plusieurs types.

Le microcomposant peut être encapsulé dans un boîtier type métallique ou céramique et ce boîtier est suffisamment grand pour accueillir un getter discret dans l'environnement proche du microcomposant. Les getters discrets disponibles ont une surface de plusieurs centaines de micromètres au carré et une épaisseur de plusieurs dizaines ou même centaines de micromètres. Le vide est effectué au moment du scellement du capot à l'embase ou à l'aide d'un queusot prévu à cet effet. Le boîtier est alors bien plus grand que le microcomposant qu'il contient. Cette solution est incompatible avec la miniaturisation qui est de plus en plus recherchée actuellement. En outre, il faut prendre en compte les problèmes rencontrés lors de la fixation du getter dans la cavité et lors de son activation thermique. Le getter se trouve en place bien avant que le microcomposant ne soit terminé et il risque d'être saturé en partie lors de l'achèvement du microcomposant encapsulé. On s'expose aussi à un risque de relargage de particules absorbées lors du procédé de fabrication et libérées ultérieurement durant la vie du microcomposant. Bien que ces particules soient fines, elles peuvent nuire au bon fonctionnement du microcomposant.

De plus, une telle structure n'est pas compatible avec les procédés d'encapsulation au niveau de la tranche connus sous la dénomination anglo-saxonne de Wafer Level Packaging. Ces procédés consistent à réaliser l'encapsulation de manière collective de tous les microcomposants qui ont été réalisés sur une même tranche de matériau semiconducteur. Ces procédés sont plus en plus employés car ils permettent de miniaturiser encore plus les composants et de réduire les coûts de fabrication de manière significative.

Il a été également proposé de reporter par scellement anodique, soudure eutectique ou autre un capot sur un substrat supportant le microcomposant. Le getter prend une forme d'un élément discret ou d'une couche mince et il est placé dans la cavité délimitée par le capot. Les problèmes d'encombrement, de saturation et de relargage de gaz existent toujours.

Dans la demande de brevet WO 2004/006290, un capot est reporté directement sur un substrat supportant le microcomposant, formant ainsi une première cavité. Le getter se trouve dans une seconde cavité creusée dans le substrat à partir d'une face opposée à celle sur laquelle se trouve le microcomposant. Les deux cavités communiquent par au moins un conduit qui passe à travers le substrat. La fabrication d'un tel microcomposant est longue et complexe. Par contre l'encombrement est moindre que celui obtenu dans les configurations évoquées précédemment.

Dans la demande de brevet WO 2004/065289, il a été préconisé soit de déposer le matériau du getter sur un support et de sceller ce support revêtu dans la cavité délimitée par le capot, soit de revêtir l'intérieur du capot avec le matériau du getter. L'inconvénient principal de cette configuration est que le getter va se saturer lors des étapes de scellement du capot et qu'il faut le protéger si l'on veut éviter cela.

La réalisation d'un capot en couches minces est une technique de plus employée dans ce type de microcomposant. Cette technique est décrite par exemple dans les demandes de brevet européen EP 0 525 764 et EP 1 101 730. La cavité délimitée par le capot ne laisse autour de la partie active du microcomposant qu'un espace de quelques dizaines ou centaines de micromètres et qu'un espace de quelques micromètres ou quelques dizaines de micromètres au-dessus du microcomposant. Il n'est pas possible d'y loger un getter discret.

La demande de brevet US 2005017313 divulgue un procédé de réalisation d'un microcomposant encapsulé. Selon ce procédé, un matériau getter est déposé de manière à ce qu'il bouche des orifices creusés dans un couvercle de type plaquette.

## EXPOSÉ DE L'INVENTION

La présente invention a pour but de remédier aux inconvénients des microcomposants encapsulés dotés d'un getter tels qu'ils viennent d'être décrits.

Un autre but de l'invention est de proposer un microcomposant encapsulé doté d'un getter qui peut être fabriqué dans sa totalité par un procédé de fabrication collective.

Un autre but de l'invention est de proposer un microcomposant encapsulé doté d'un getter et dont le capot peut être réalisé en couches minces.

Un autre but de l'invention est de proposer un microcomposant encapsulé doté d'un getter qui ne risque pas d'être saturé avant l'achèvement du microcomposant et qui de ce fait n'a pas besoin d'être protégé pour éviter cette saturation ou même d'être activé avant un premier fonctionnement.

Un autre but de l'invention est de proposer un microcomposant encapsulé doté d'un getter qui peut servir de renfort au capot.

Pour y parvenir la présente invention est un microcomposant encapsulé selon la revendication 1.

Il est possible que le bouchon comporte également au moins une partie d'étanchéité qui surmonte la partie en matériau getter.

De préférence, le matériau getter de la partie en matériau getter a une structure colonnaire de manière à posséder une capacité d'absorption de gaz aussi bonne que possible.

En variante, pour améliorer l'étanchéité du capot, il est possible de prévoir que le matériau de la partie en matériau getter possède une première zone à structure colonnaire qui se prolonge par une seconde zone à structure cristallisée, la zone à structure colonnaire étant plus éloignée du capot que la zone à structure cristallisée.

On peut par exemple choisir le matériau getter parmi le titane, le vanadium, le zirconium, le baryum ou leurs mélanges.

La partie d'étanchéité peut être réalisée dans un matériau métallique choisi parmi l'or, le platine, le chrome l'aluminium ou leurs mélanges ou dans un matériau diélectrique choisi parmi le nitrure de silicium, l'oxyde de silicium.

Le bouchon peut venir en contact avec le substrat au niveau de sa partie en matériau getter.

Le capot peut comporter une partie qui délimite une cavité active et une partie qui délimite un canal de pompage d'épaisseur moindre que la cavité active, la cavité active communiquant avec le canal de pompage, l'orifice débouchant dans le canal de pompage et/ou dans la partie active.

Une autre configuration peut être que le capot comporte une paroi sommitale dans laquelle se trouve le bouchon.

Une partie active du microcomposant est logée dans la cavité et est supportée par un substrat sur lequel prend appui le capot. Il est possible que la partie en matériau getter passe à travers une lacune dont est dotée la partie active.

Le capot prenant appui sur le substrat, une électrode d'une paire d'électrodes d'un dispositif d'activation du matériau getter peut être interposée entre la partie en matériau getter du bouchon et le substrat.

L'autre électrode de la paire d'électrodes du dispositif d'activation du matériau getter peut être portée par le capot, cette autre électrode s'étendant soit à l'intérieur de la cavité soit à l'extérieur de la cavité et venant en contact avec le matériau getter à proximité de l'orifice.

L'autre électrode de la paire d'électrodes du dispositif d'activation du matériau getter peut servir de partie d'étanchéité.

La présente invention concerne également un procédé de réalisation d'un microcomposant encapsulé comportant les étapes consistant à :

- recouvrir de matériau sacrificiel un substrat supportant une partie active du microcomposant, ce matériau sacrificiel servant de forme pour le capot du microcomposant ;
- déposer sur le matériau sacrificiel un matériau d'encapsulation de manière à former un capot délimitant une cavité ;
- ouvrir un ou plusieurs orifices dans le matériau d'encapsulation ;
- éliminer le matériau sacrificiel par les orifices ;
- déposer un matériau getter sur le capot de manière à ce qu'il soit exposé à l'intérieur de la cavité et bouche totalement ou partiellement les orifices et repose sur le substrat en vis-à-vis des orifices.

Le dépôt du matériau getter peut se faire par évaporation sous vide, sur une surface dont la température est comprise entre environ 0,2 et 0,5 fois la température de fusion du matériau getter au moins au début, de manière à obtenir une structure de dépôt colonnaire du matériau getter, les températures s'exprimant en degrés Kelvin.

Le dépôt du matériau getter peut se faire par la suite, dans les mêmes conditions de pression, mais sur une surface dont la température est supérieure à environ 0,5 fois la température de fusion du matériau getter de manière à obtenir une structure de dépôt cristallisée du matériau getter.

Pour améliorer l'étanchéité, on peut prévoir une étape de dépôt d'une première couche d'étanchéité et d'éventuellement d'une seconde couche d'étanchéité sur la première couche d'étanchéité, la première et la seconde couche d'étanchéité surmontant le matériau getter.

Le dépôt de la première couche d'étanchéité peut se faire à sensiblement à la même pression que le dépôt du matériau getter.

On peut prévoir une étape de gravure du matériau getter ainsi que de la première couche d'étanchéité, si elle existe, pour ne conserver au niveau de chaque orifice qu'un bouchon et ainsi réduire le volume du microcomposant encapsulé, et dans le cas par exemple d'un composant optique, ne pas masquer le rayonnement optique à détecter ou à émettre.

De manière similaire, on peut prévoir une étape de gravure de la seconde couche d'étanchéité pour parfaire le bouchon.

On peut également prévoir une étape de dépôt, sur le substrat, d'une électrode, par orifice, d'un dispositif d'activation du matériau getter, cette électrode ayant une extrémité localisée en vis-à-vis de l'orifice, destinée à venir en contact électrique avec le matériau getter.

On prévoit alors une étape de dépôt d'une autre électrode du dispositif d'activation du matériau getter, soit sur le matériau sacrificiel, soit sur le matériau d'encapsulation, cette autre électrode devant venir au contact du matériau getter à proximité de l'orifice.

Il est possible d'inclure une étape de dégazage après l'étape d'élimination du matériau sacrificiel et avant l'étape de dépôt du matériau getter pour limiter la quantité de gaz à absorber par le matériau getter pendant la durée de vie du microcomposant.

## BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :

les figures 1A, 1B montrent en vue de dessus et en coupe un premier exemple d'un microcomposant selon l'invention ;
les figures 2A et 2B montrent en vue de dessus et en coupe un autre exemple d'un microcomposant selon l'invention ;
la figure 3 montre un bouchon en matériau getter destiné à boucher le capot du microcomposant de l'invention ;
les figures 4A, 4B, 4C montrent encore d'autres exemples de microcomposants selon l'invention ;
Les figures 5A à 5K montrent différentes étapes d'un procédé de réalisation d'un microcomposant selon l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

## EXPOSÉ DÉTAILLÉ DE MODES DE RÉALISATION PARTICULIERS

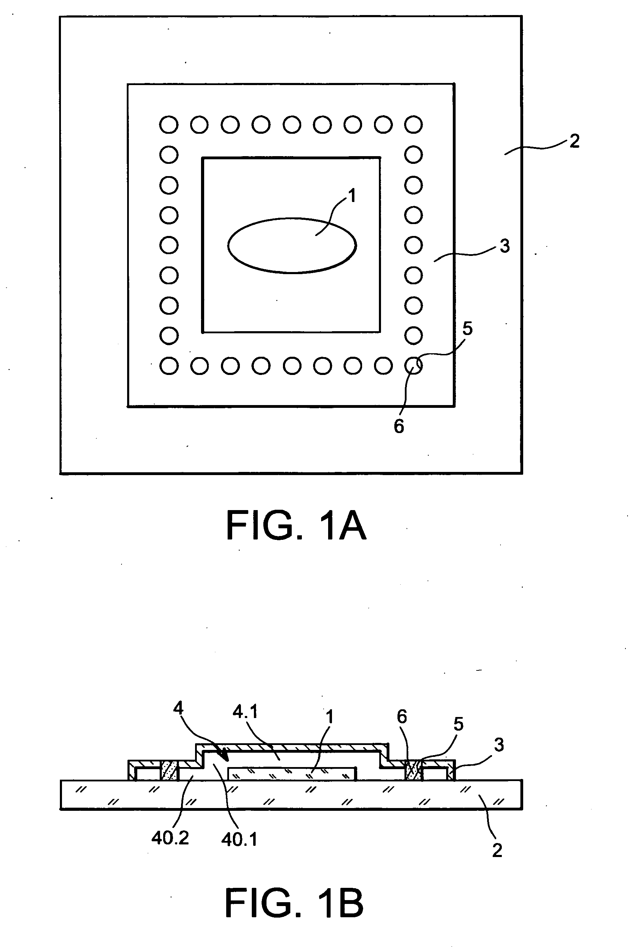

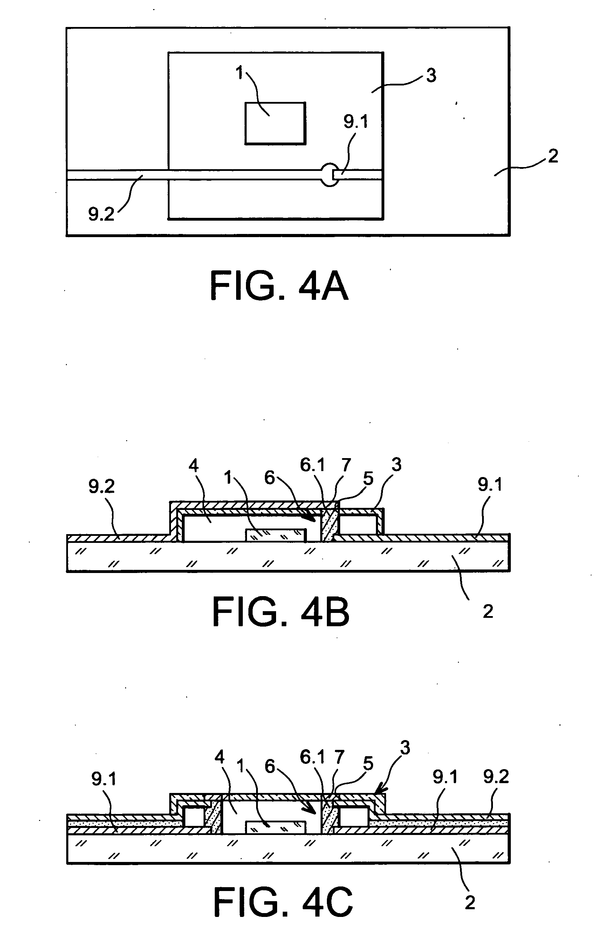

On va maintenant se référer aux figures 1A, 1B qui montrent un exemple de microcomposant encapsulé conforme à l'invention. Le microcomposant encapsulé selon l'invention comporte une partie active 1, par exemple un actionneur, un résonateur ou tout autre composant électronique, optique, optoélectronique ou électromécanique, supportée par un substrat 2. Un capot 3 recouvre la partie active 1 et délimite une cavité 4 dans laquelle est enfermée la partie active 1. Le capot 3 prend appui sur le substrat 2. Ce capot 3 ayant été réalisé par la technologie de couche mince, il comporte au moins un orifice d'évacuation 5 d'un matériau sacrificiel (non représenté) qui a servi de forme pour délimiter le contour intérieur du capot 3, c'est-à-dire la cavité 4. Cet orifice 5 est bouché par un bouchon 6 ayant au moins une partie 6.1 en matériau getter exposée à l'intérieur de la cavité 4. Le bouchon peut être en totalité en matériau getter s'il est suffisamment étanche pour l'application envisagée. Si ce n'est pas le cas, il est possible de lui adjoindre au moins une partie d'étanchéité 7 comme illustré sur la figure 4C.

Cette configuration sera également employée si la pression dans la cavité 4, régnant lors du dépôt du matériau getter n'est pas assez basse par rapport à celle requise lors du fonctionnement du microcomposant. La partie en matériau getter 6.1 n'obstrue pas complètement l'orifice, et lorsque la pression à l'intérieur de la cavité 4 a atteint la valeur requise, on obstrue l'orifice 5 de manière étanche avec la partie d'étanchéité 7, ce qui parfait le bouchon 6.

Le matériau getter peut être choisi par exemple parmi le titane, le vanadium, le zirconium, le molybdène, le baryum ou leurs mélanges. Le choix du matériau getter se fait en fonction des contraintes de température, de la nature des gaz à piéger et de la capacité de pompage requise.

La partie d'étanchéité 7 peut être réalisée à base d' or, de platine, de chrome, d' aluminium ou même de nitrure de silicium ou d'oxyde de silicium par exemple.

La partie en matériau getter 6.1 du bouchon 6 sera suffisamment étanche notamment si son épaisseur est suffisante.

Il est également possible d'atteindre l'étanchéité souhaitée en modifiant en cours de réalisation du bouchon la structure du matériau getter, comme on pourra le voir par la suite.

La quantité de matériau getter à utiliser est calculée pour qu'elle puisse absorber toutes les impuretés susceptibles d'apparaître dans une cavité 4 de volume V dans laquelle règne une pression P pendant le fonctionnement du microcomposant. Elle peut se définir par sa surface S qui se trouve à l'intérieur de la cavité 4 et qui s'exprime par:

S= (PxV)/($\alpha$xC) avec $\alpha$ taux d'activation du matériau getter et C capacité de pompage du matériau getter en Pa.cm$^3$.cm$^{-2}$. La capacité théorique de pompage du titane est très importante, elle vaut $5,2.10^4$ Pa.cm$^3$. mg$^{-1}$, ce qui représente $2,7.10^4$ Pa.cm$^3$-mg$^{-1}$ pour une épaisseur de 1 micromètre.

On applique cette formule à une cavité 4 dont le volume est de 200x200x4 micromètres au carré, dans laquelle la pression est de $6,7.10^{-1}$ Pa. On considère que la capacité de pompage effective du titane employé est de $1,34 .10^2$ Pa.cm$^3$.cm$^{-2}$ et que son taux d'activation est de 50%. La surface active du matériau getter en contact avec l'intérieur de la cavité 4, pour avoir la capacité de pompage requise devient

$$S = [6,7.10^{-1}.(200.10^{-4})^2.4.10^{-4}]/0,5.133,3$$

$$S = 1,6.10^{-7} \ cm^2$$

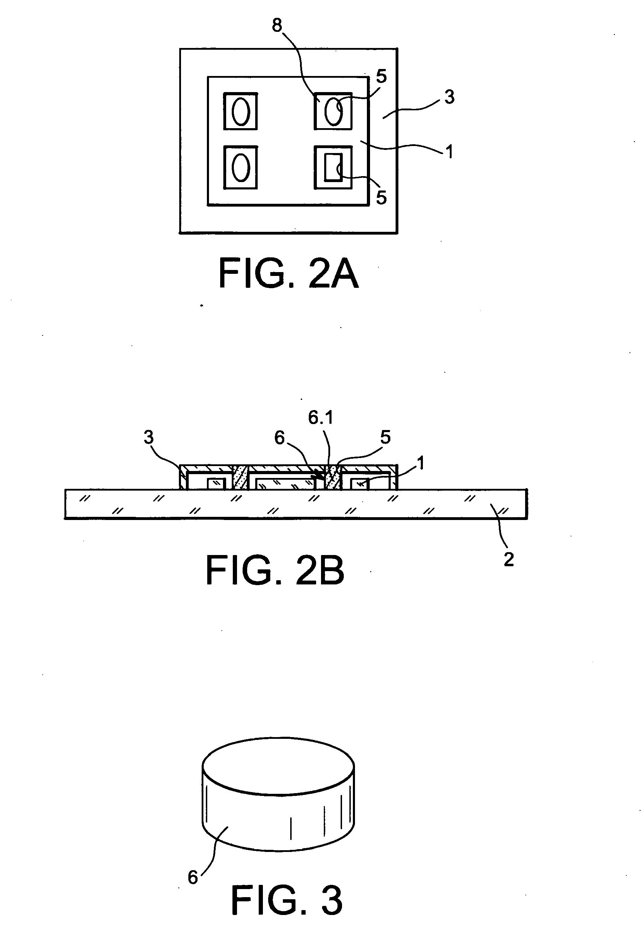

Cette valeur de surface peut être obtenue par exemple par six bouchons cylindriques à section circulaire dont le diamètre est de 2 micromètres et la hauteur de la surface utilisable dans la cavité 4 de 1 micromètre. De tels bouchons 6 sont illustrés sur la figure 3, on suppose qu'ils sont en totalité en matériau getter à structure colonnaire.

Il est préférable, pour une quantité de matériau getter donnée, de la répartir sur plusieurs bouchons 6 au lieu d'un seul qui risquerait de fragiliser le capot 3.

Les orifices 5 à boucher par le matériau getter, ne sont pas forcément circulaires, ils peuvent avoir un rapport longueur sur largeur supérieur à un, être oblongs comme l'illustre la figure 1A ou bien encore être en quadrilatère. Lors du choix de leur forme et de leur taille, il faut juste veiller à ce qu'ils ne fragilisent pas le capot et qu'ils puissent être correctement bouchés.

Sur la figure 1A, on suppose que le capot 3 a une emprise carrée de 210 micromètres de côté sur le substrat 2. Il est formé d'une partie centrale 3.1 qui délimite une cavité active 40.1 dans laquelle se trouve la partie active 1 du microcomposant et d'une partie périphérique 3.2 qui délimite un canal de pompage 40.2. La partie centrale 3.1 peut être un carré de 200 micromètres de côté. La cavité active 40.1 et le canal de pompage 40.2 communiquent.

La hauteur de la cavité active 40.1 est supérieure à celle du canal de pompage 40.2. Dans l'exemple des figures 1A, 1B, on suppose que la hauteur de la partie centrale est de 4 micromètres et que celle de la partie périphérique de 1 micromètre.

Les orifices 5 sont répartis dans la partie périphérique 3.2. On suppose que sur les quatre côtés de la partie périphérique sont répartis sensiblement régulièrement 51 orifices 5 de 2 micromètres de diamètre. Les orifices 5 ainsi répartis délimitent un carré de 204 micromètres de côté. On dispose ainsi d'un total de 204 orifices. Le pas des orifices circulaires est de 4 micromètres. Si les orifices sont bouchés par des bouchons de titane tels qu'illustrés à la figure 3, la capacité de pompage est portée à $4,2.10^{-4}$ Pa.cm$^3$. cm$^{-2}$. Cette capacité de pompage peut aisément compenser des remontées de pression dues à des dégazages et au passage de gaz à travers des matériaux constitutifs du microcomposant et ce durant toute sa durée de vie. En variante, on aurait pu utiliser des orifices oblongs ou en quadrilatère, comme sur la figure 2A, présentant la même surface de pompage.

La partie en matériau getter 6.1 d'un bouchon 6 vient en appui sur le substrat 2, à cause du procédé de dépôt utilisé dans l'ensemble décrit. En fait rien n'oblige qu'il soit en contact avec le substrat.

Sur la figure 2, le capot ne comporte qu'une seule partie qui délimite la cavité 4 dans laquelle se trouve la partie active 1 avec une paroi sommitale 4.1 et des parois latérales 4.2. Il n'est pas nécessaire de confiner les orifices 5 en périphérie de la paroi sommitale 4.1. Ces derniers peuvent se trouver dans la partie centrale de la paroi sommitale 4.1 au dessus de la partie active 1. Cette configuration permet de gagner de la place sur le substrat par rapport à celle illustrée aux 1A, 1B. On dispose de toute la surface de la paroi sommitale 4.1 pour disposer les orifices 5. Dans la mesure où la partie en matériau getter 6.1 des bouchons 6 prend appui sur le substrat 2, on prévoit de pourvoir la partie active 1 du microcomposant d'une épargne 8, pour chaque bouchon 6, au travers de laquelle il pourra atteindre le substrat 2. Les bouchons 6 forment alors des piliers dont la base est en appui sur le substrat 2. Cette configuration est particulièrement recommandée pour les grands capots 3 par exemple ceux dont la paroi sommitale est de l'ordre d'au moins 300 micromètres par 300 micromètres. De tels bouchons 6 ont un rôle de renfort mécanique du capot 3 et ils ne gênent en rien le fonctionnement de la partie active 1 du microcomposant.

En réalisant le capot 3, il est possible d'adapter sa hauteur, au moins localement au niveau d'un orifice 5, pour pouvoir, par une étape de dépôt généralement par évaporation à basse pression comme on le décrira ultérieurement, boucher cet orifice 5. Une hauteur inférieure à par exemple 0,5 micromètre est trop petite et une hauteur supérieure à plusieurs micromètre est trop grande. Une valeur de l'ordre du micromètre est optimale pour ce type de matériau et ce procédé de dépôt.

Il est possible d'envisager que dans le cas d'un capot 3 avec partie périphérique et partie centrale, les orifices 5 soient répartis à la fois sur la partie périphérique et sur la partie centrale.

Le procédé de dépôt du matériau getter que l'on va décrire ultérieurement fait qu'il peut ne pas être nécessaire d'activer le matériau getter juste après le bouchage des orifices. Toutefois, durant la vie du microcomposant, une activation peut être requise dès que la partie en matériau getter aura une surface saturée, c'est-à-dire dès que des impuretés qui ont été piégées en surface empêcheront le phénomène de piégeage de se poursuivre. Il suffit de chauffer le matériau getter à une température suffisante pour que les impuretés piégées diffusent en profondeur et rendent de nouveau la surface opérationnelle. On régénère la surface active du matériau getter pour conserver sa fonction de pompage. Cette régénération peut se faire par effet Joule produit par circulation d'un courant à travers le bouchon. Il est préférable de ne pas chauffer globalement le microcomposant, car cela risque de perturber voire de détruire sa partie active. Les figures 4A, 4B illustrent succinctement un dispositif d'activation locale du matériau getter du bouchon 6.

On prévoit une paire d'électrodes 9.1, 9.2 qui coopère avec chaque bouchon 6 pour l'amenée et la récupération du courant qui va le traverser. L'une des électrodes 9.1 s'étend sur le substrat 2, elle possède une extrémité qui atteint la base du bouchon 6 et est en contact électrique avec lui au niveau de sa partie en matériau getter 6.1. L'autre électrode 9.2 est supportée par le capot 3. Elle peut se trouver à l'intérieur de la cavité 4 comme sur la figure 4C ou à l'extérieur comme sur la figure 4B. On s'arrange pour que l'électrode 9.2 supportée par la capot 3, ne perturbe pas un rayonnement optique à détecter ou à émettre par la partie active 1 du composant si elle est optique, comme illustré sur la figure 4A.

L'autre électrode 9.2 possède également une extrémité qui atteint le sommet du bouchon 6 et préférentiellement le sommet de sa partie en matériau getter 6.1. Elle vient en contact électrique avec le matériau getter à proximité de l'orifice 5. Cette variante convient aussi s'il y a la partie d'étanchéité 7. Les deux électrodes 9.1, 9.2 d'une paire sont isolées électriquement l'une de l'autre.

Les électrodes 9.1, 9.2 peuvent être réalises par exemple en alliage d'or et de chrome ou d'or et de titane, le chrome et le titane assurant l'adhérence de l'or.

L'électrode 9.2 se trouve au moins en partie au niveau de l'orifice 5 de manière à ce que le matériau getter se dépose au moins en partie au dessus pour assurer un contact électrique.

Si l'électrode 9.2 se trouve à l'extérieur de la cavité 4 comme sur la figure 4B, et qu'elle recouvre totalement la surface de la partie en matériau getter 6.1 du bouchon 6, la plus proche de l'orifice 5 du capot 3, l'extrémité de cette électrode 9.2 peut faire office de partie d'étanchéité 7. Dans ce cas, elle sera déposée dans la même chambre à vide que celle employée pour réaliser la partie en matériau getter 6.1 du bouchon 6.

En variante, comme illustré sur la figure 4C, on peut s'arranger pour que la surface de l'électrode 9.1 ou 9.2 en contact avec le matériau getter soit la plus faible possible pour ne par trop réduire la surface du matériau getter exposée dans la cavité 4. La surface de la partie en matériau getter 5.1, la plus proche de l'orifice 5 et/ou la base du bouchon 6 peuvent n'être en contact que partiel avec l'électrode correspondante 9.1 ou 9.2. Avec cette structure, on conserve ainsi une surface libre la plus grande possible du matériau getter en terme de capacité de pompage.

On va maintenant s'intéresser à un exemple de procédé de fabrication d'un microcomposant encapsulé selon la présente invention.

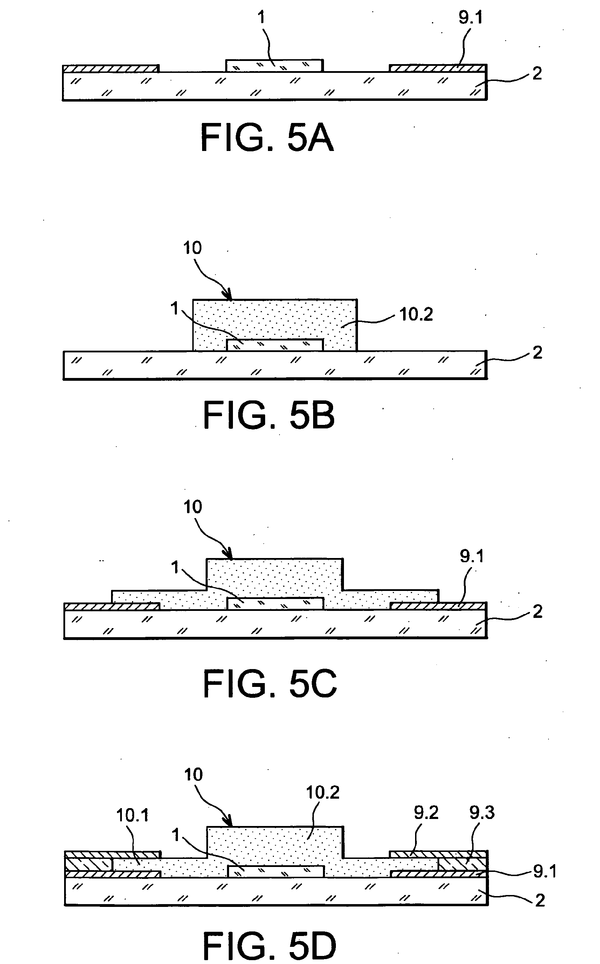

On part d'un substrat 2 qui supporte la partie active 1 du microcomposant (figure 5A). On ne décrit pas plus cette étape car elle ne pose pas de problème à un homme du métier et dépend du type de microcomposant envisagé.

Si l'on prévoit une paire d'électrodes pour activer le matériau getter de chaque bouchon, on dépose l'une des électrodes 9.1 de chaque paire sur le substrat 2. Une extrémité de cette électrode 9.1 se trouvera à l'endroit où la partie en matériau getter du bouchon bute sur le substrat 2, c'est-à-dire en vis-à-vis de l'orifice qui sera fait ultérieurement. L'autre extrémité sera accessible de l'extérieur du capot. Les électrodes 9.1, 9.2 peuvent être en alliage or titane ou or chrome comme vu précédemment. L'électrode 9.1 peut être déposée par pulvérisation cathodique ou évaporation sous vide par exemple.

On va déposer sur le substrat 2 et la partie active 1 une ou deux couches 10.1, 10.2 de matériau sacrificiel. On suppose que dans l'exemple de la figure 5B on n'a déposé qu'une seule couche 10.2 parce que le capot ne délimite qu'une cavité au-dessus de la partie active du microcomposant et que le microcomposant est dépourvu de dispositif d'activation du matériau getter. Par contre sur la figure 5C, on a déposé deux couches 10.1, 10.2, la première 10.1 contribuant à délimiter le canal de pompage et la seconde contribuant à délimiter la cavité active au dessus de la partie active du microcomposant. Le matériau sacrificiel 10 peut être par exemple un polymère tel qu'une résine photosensible, par exemple celle de JSR Corporation de référence JSR PFR420 ou de type de type AZ4562. On recuit chacune des couches 10.1, 10.2 après leur dépôt à une température d'environ 350°C. Le recuit se fait après la délimitation qui est expliquée ci-dessous.

On délimite, par photolithographie, chacune des couches 10.1, 10.2 après leur dépôt au contour intérieur du canal de pompage et de la cavité active. S'il n'y a qu'une seule couche déposée, la délimitation se fait au contour de l'intérieur de la cavité. La première couche 10.1 de matériau sacrificiel peut avoir une épaisseur d'environ 0,2 à 1 micromètre, tandis que la seconde couche 10.2 (ou la couche unique) peut avoir une épaisseur d'environ 4 à 10 micromètres au-dessus de la partie active du microcomposant encapsulé.

Si on prévoit une paire d'électrodes 9.1, 9.2 pour l'activation du matériau getter et que la seconde électrode 9.2 doit se trouver à l'intérieur de la cavité, on la dépose sur le matériau sacrificiel 10, après sa délimitation, en prenant garde qu'elle ne vienne pas en contact avec la première électrode 9.1 de la paire. Sur la figure 5D, la seconde électrode 9.2 est représentée. On suppose qu'au niveau du substrat 2, elle surmonte la première électrode 9.1, en en étant isolée par du matériau diélectrique 9.3. Elle aura une extrémité accessible à l'extérieur de la cavité. La seconde électrode 9.2 peut être, par exemple, déposée par pulvérisation cathodique ou évaporation sous vide.

Par la suite, on suppose que la seconde électrode 9.2 sera déposée à l'extérieur de la cavité et que son dépôt aura donc lieu après la réalisation du capot. Dans ce mode de réalisation, le dépôt se fait préférentiellement par évaporation sous vide.

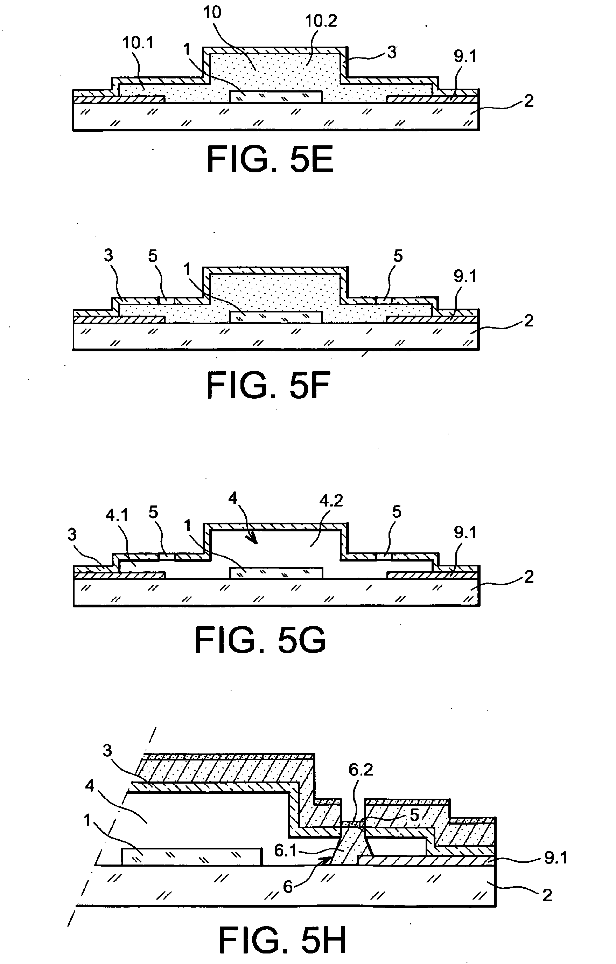

On dépose donc sur le matériau sacrificiel 10 ainsi délimité le capot 3 en une ou plusieurs couches de matériau d'encapsulation. Le dépôt est un dépôt conforme. Cette étape est illustrée à la figure 5E. Cette figure 5E illustre la réalisation d'un capot 3 délimitant une cavité 4 avec partie active 4.2 et canal de pompage 4.1. On n'a pas représenté la suite du procédé dans le cas où le capot ne possède pas de canal de pompage pour ne pas multiplier inutilement les figures. Ce sont les mêmes étapes qui sont employées dans les deux cas.

Le matériau d'encapsulation 3 est de préférence un matériau diélectrique tel que de l'oxyde de silicium ou du nitrure de silicium. Lorsqu'on prévoit un dépôt multicouche, on peut alterner ces deux matériaux. D'autres matériaux pourraient être envisagés tels que le silicium amorphe.

Le dépôt peut être par exemple d'un dépôt chimique en phase vapeur activé par plasma (en anglais Plasma Enhanced Chemical Vapor Déposition, connu avec l'abréviation PECVD) ou d'un dépôt chimique en phase vapeur à basse pression (en anglais Low Pressure Chemical Vapor Déposition, connu avec l'abréviation LPCVD).

L'épaisseur du matériau d'encapsulation réalisant le capot 3 peut être comprise entre environ 1 et 3 micromètres. Un capot en nitrure de silicium SiN ou $Si_3N_4$ ou en oxyde de silicium $SiO_2$ pourra avoir une épaisseur comprise entre environ 1 et 3 micromètres. Une épaisseur typique d'un capot en oxyde de silicium pourra être par exemple de 1,5 micromètre.

On va ensuite graver dans le matériau d'encapsulation un ou plusieurs orifices 5 (figure 5F). Dans l'exemple décrit, les orifices 5 ont été gravés au niveau du canal de pompage mais il est bien sûr possible de les graver au niveau de la partie active de la cavité. La gravure peut être par exemple une gravure sèche plasma avec gaz fluoré $CF_4$ ou $SF_6$.

On va ensuite éliminer le matériau sacrificiel 10 en le faisant s'évacuer par les orifices 5 (figure 5G). Cette évacuation peut se faire par exposition à un plasma d'oxygène qui élimine les résidus organiques.

On peut procéder ensuite à une étape de dégazage des matériaux présents à l'intérieur de la cavité 4. Cela peut se faire à haute température sous vide. On peut par exemple réaliser ce dégazage à une température de 200°C pendant quelques heures. Cette étape n'est pas indispensable mais elle permet de limiter la quantité de gaz à pomper pendant la durée de vie du microcomposant.

On va ensuite boucher chaque orifice 5 par un bouchon 6, en commençant par la partie en matériau getter 6.1 (figure 5H). La figure 5H n'est que partielle. Ce dépôt, par exemple de titane, peut se faire par évaporation à basse pression, par exemple de l'ordre de $5.10^{-4}$ Pa. Cette technique de dépôt se faisant par évaporation à basse pression, la quantité de gaz à pomper sera faible si on la compare à celle obtenue avec les techniques de scellement sous vide à des pressions qui peuvent être mille fois plus élevées.

On porte la surface sur laquelle doit se déposer le matériau getter, c'est-à-dire le capot 3 et le substrat 2 à l'intérieur de la cavité à une température Td (en degré Kelvin) telle que le rapport Td/Tf soit d'environ 0,2 à 0,5. Tf représente la température de fusion du matériau getter, par exemple pour le titane 1941°K. Avec de telles conditions de dépôt, la structure du titane déposé est colonnaire. Elle est poreuse et présente de nombreux joints entre les différents grains qui constituent la couche, cela induit une grande surface de contact possible avec le gaz à pomper et est donc propice à une grande capacité de pompage.

Dans la pratique, on obtient un matériau granulaire : les grains sont solidaires les uns des autres par des joints de grains. Le matériau doit sa structure aux conditions du dépôt. La structure colonaire correspond au cas le plus favorable. Dans ce cas, la plus grande dimension des colonnes correspond à la direction du dépôt.

L'homme du métier pourra s'appuyer sur le modèle de Movchan et Demchishin pour déterminer le rapport Td/Tf qui donnera la meilleure structuration pour un effet getter maximum adapté à chaque matériau déposé.

L'effet getter est présent dès qu'un peu de matériau est déposé, ce matériau étant déposé dans l'environnement proche de la partie active 1, cela assure une pression encore plus faible à l'intérieur de la cavité dès le début de la fermeture. Le matériau getter se dépose sur le substrat en vis-à-vis de l'orifice avec ce type de procédé.

Le dépôt de la partie en matériau getter 6.1 peut assurer le bouchage hermétique de la cavité si ladite partie est suffisamment épaisse. On suppose que cette configuration est celle illustrée sur la figure 2B, c'est pourquoi elle n'est pas de nouveau représentée.

On peut au cours du dépôt du matériau getter, on peut être amené à changer les conditions de dépôt pour qu'il change de structure et recristallise ; Cette étape est également illustrée sur la figure 5H. A ce moment le dépôt devient étanche. Le changement de conditions de dépôt peut être un changement de température, on peut s'arranger pour avoir un rapport Td/Tf supérieur à environ 0,5. La partie recristallisée est référencée 6.2. Elle forme ou contribue à former la partie d'étanchéité du bouchon 6. Dans cette configuration, la partie en en matériau getter comporte alors une zone à structure colonnaire qui se prolonge par une zone à structure cristallisée.

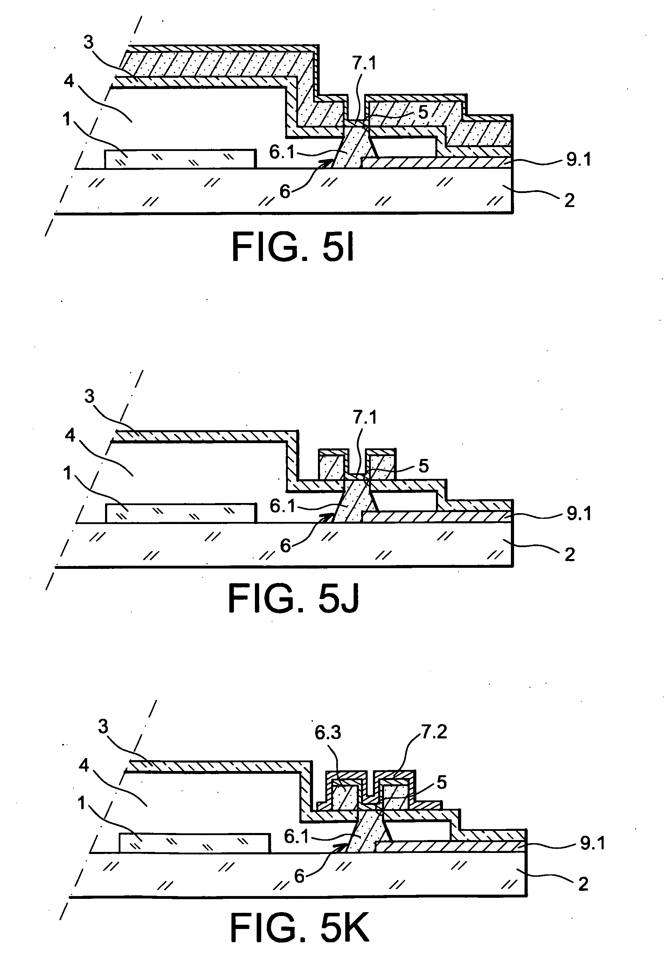

En variante ou en complément, pour obtenir l'étanchéité, il est possible de changer de métal, en gardant la même pression (figure 5I). On peut par exemple déposer une couche d'étanchéité 7.1 par exemple en or d'une épaisseur d'environ 1 micromètre sur le matériau getter et ainsi former ou contribuer à former la partie d'étanchéité. La température doit être adaptée au nouveau métal employé. De la sorte on ne soumet pas le matériau getter à la pression atmosphérique. La première couche d'étanchéité 7.1 pourrait aussi être en diélectrique, comme expliqué plus loin pour la seconde couche d'étanchéité 7.2.

Il est possible, au cours d'une étape classique de photolithographie, de graver le ou les matériaux déposés pour délimiter localement le contour des bouchons 6 et éliminer lesdits matériaux ailleurs en mettant à nu le capot 3 (figure 5J). Cette étape convient particulièrement si le composant est un composant optique puisqu'il ne faut pas masquer le rayonnement optique que le composant doit émettre ou détecter. On peut aussi choisir de conserver le ou les matériaux déposés mais de délimiter localement le contour des bouchons par gravure. Cette étape est facultative. La couche d'étanchéité 7.1 peut servir de seconde électrode à la paire d'électrodes du dispositif d'activation de la partie en matériau getter 6.1.

Si le microcomposant encapsulé doit avoir une durée de vie très longue, il peut être intéressant de prévoir, en outre, une seconde couche d'étanchéité 7.2 sur les bouchons 6 tels qu'ils sont au stade de la figure 5K pour améliorer l'étanchéité dans la cavité 4. La couche d'étanchéité 7.1 étant la première couche d'étanchéité. Cette seconde couche d'étanchéité 7.2 est représentée à la figure 5K. Cette seconde couche d'étanchéité 7.2 peut être métallique ou diélectrique. Le métal pour la première couche d'étanchéité ou la seconde couche d'étanchéité peut être choisi parmi l'or, le platine, le chrome, l'aluminium ou leurs mélanges. La liste n'est pas exhaustive. Le diélectrique de la seconde couche d'étanchéité peut être choisi parmi le $SiO_2$, le SiN ou le $Si_3N_4$. La seconde couche d'étanchéité 7.2 pourrait être formée de plusieurs sous couches de ces matériaux. Dans le cas où il n'y a pas d'électrode d'activation, cette seconde couche peut être diélectrique. Cette seconde couche d'étanchéité 7.2 renforce l'étanchéité du bouchage notamment au niveau de zones latérales 6.4 des bouchons 6 qui après la délimitation possédaient du matériau getter à nu à l'extérieur de la cavité 4, c'est-à-dire au niveau des passages de marches. De la même manière que précédemment la seconde couche 7.2 peut être gravée localement au contour des bouchons 6 et éliminée ailleurs.

Bien que plusieurs modes de réalisation de la présente invention aient été représentés et décrits de façon détaillée, on comprendra que différents changements et modifications puissent être apportés sans sortir du cadre de l'invention. Les différentes variantes décrites doivent être comprises comme n'étant pas forcément exclusives les unes des autres.

**Revendications**

1. Microcomposant encapsulé possédant un capot (3) prenant appui sur un substrat (2), délimitant une cavité étanche et doté d'au moins un orifice (5) pourvu d'un bouchon (6) qui comporte une partie (6.1) en matériau getter exposée à l'intérieur de la cavité et **caractérisé en ce que** du matériau getter se trouve sur le substrat (2) en vis-à-vis de l'orifice (5).

2. Microcomposant selon la revendication 1, dans lequel le bouchon (6) comporte également au moins une partie (7) d'étanchéité qui surmonte la partie (6.1) en matériau getter.

3. Microcomposant selon la revendication 1, dans lequel le matériau getter de la partie (6.1) en matériau getter a une structure colonnaire.

4. Microcomposant selon la revendication 1, dans lequel le matériau de la partie (6.1) en matériau getter possède une première zone à structure colonnaire qui se prolonge par une seconde zone (6.2) à structure cristallisée, la zone à structure colonnaire étant plus éloignée du capot que la zone à structure cristallisée.

**5.** Microcomposant selon l'une des revendications 1 à 4, dans lequel le matériau getter est choisi parmi le titane, le vanadium, le zirconium, le baryum ou leurs mélanges.

**6.** Microcomposant selon l'une des revendications 1 à 5, dans lequel la partie (7) d'étanchéité est réalisée dans un matériau métallique choisi parmi l'or, le platine, le chrome, l'aluminium ou leurs mélanges ou dans un matériau diélectrique choisi parmi le nitrure de silicium, l'oxyde de silicium.

**7.** Microcomposant selon l'une des revendications 1 à 6, dans lequel le bouchon (6) vient en contact avec le substrat (2) au niveau de sa partie (6.1) en matériau getter.

**8.** Microcomposant selon l'une des revendications 1 à 7, dans lequel le capot (3) comporte une partie qui délimite une cavité active (40.1) et une partie qui délimite un canal de pompage (40.2) d'épaisseur moindre que la cavité active, la cavité active communiquant avec le canal de pompage, l'orifice (5) débuchant dans le canal de pompage et/ou dans la partie active.

**9.** Microcomposant selon l'une des revendications 1 à 8, dans lequel le capot (3) comporte une paroi sommitale (4.1) dans laquelle se trouve le bouchon (6).

**10.** Microcomposant selon l'une des revendications 1 à 9, comportant une partie active (1) logée dans la cavité (4) et supportée par un substrat (2) sur lequel prend appui le capot (3), dans lequel la partie (6.1) en matériau getter passe à travers une lacune (8) dont est dotée la partie active (1).

**11.** Microcomposant selon l'une des revendications 1 à 10, dans lequel le capot (3) prend appui sur le substrat (2), une électrode (9.1) d'une paire d'électrodes (9.1, 9.2) d'un dispositif d'activation du matériau getter étant interposée entre la partie (6.1) en matériau getter du bouchon (6) et le substrat (2).

**12.** Microcomposant selon la revendication 11, dans lequel l'autre électrode (9.2) de la paire d'électrodes du dispositif d'activation du matériau getter est portée par le capot (3), cette autre électrode (9.2) étant s'étendant soit à l'intérieur de la cavité soit à l'extérieur de la cavité (4) et venant en contact avec le matériau getter à proximité de l'orifice (5).

**13.** Microcomposant selon la revendication 12, dans lequel l'autre électrode (9.2) de la paire d'électrodes du dispositif d'activation du matériau getter sert de partie d'étanchéité.

**14.** Procédé de réalisation d'un microcomposant encapsulé comportant les étapes consistant à :

- recouvrir de matériau sacrificiel (10) un substrat (2) supportant une partie active (1) du microcomposant, ce matériau sacrificiel (10) servant de forme pour le capot du microcomposant ;
- déposer sur le matériau sacrificiel un matériau d'encapsulation de manière à former un capot (3) délimitant une cavité (4) ;
- ouvrir un ou plusieurs orifices (5) dans le matériau d'encapsulation ;
- éliminer le matériau sacrificiel par les orifices (5) ;
- déposer un matériau getter sur le capot (3) de manière à ce qu'il soit exposé à l'intérieur de la cavité, bouche totalement ou partiellement les orifices (5) et repose sur le substrat (2) en vis-à-vis des orifices (5).

**15.** Procédé de réalisation d'un microcomposant encapsulé selon la revendication 14, dans lequel le dépôt du matériau getter se fait par évaporation sous vide, au moins au début, sur une surface dont la température est comprise entre environ 0,2 fois et 0,5 fois la température de fusion du matériau getter de manière à obtenir une structure de dépôt colonnaire du matériau getter, les températures s'exprimant en degrés Kelvin.

**16.** Procédé de réalisation d'un microcomposant encapsulé selon la revendication 15, dans lequel le dépôt du matériau getter se fait, par la suite, dans les mêmes conditions de pression mais sur une surface dont la température est supérieure à environ 0,5 fois la température de fusion du matériau getter de manière à obtenir une structure de dépôt cristallisée du matériau getter.

**17.** Procédé de réalisation d'un microcomposant encapsulé selon l'une des revendications 14 à 16, dans lequel on prévoit une étape de dépôt d'une première couche d'étanchéité (7.1) et d'éventuellement d'une seconde couche d'étanchéité (7.2) sur la première couche d'étanchéité, la première et la seconde couche d'étanchéité surmontant le matériau getter.

**18.** Procédé de réalisation d'un microcomposant encapsulé selon la revendication 17, dans lequel le dépôt de la première couche d'étanchéité (7.1) se fait à sensiblement à la même pression que le dépôt du matériau getter.

**19.** Procédé de réalisation d'un microcomposant encapsulé selon l'une des revendications 14 à 18, dans lequel on prévoit une étape de gravure du matériau getter ainsi que de la première couche d'étanchéité (7.1) si elle existe pour ne conserver au niveau de chaque orifice qu'un bouchon (6).

**20.** Procédé de réalisation d'un microcomposant encapsulé selon la revendication 19, dans lequel on prévoit une étape de gravure de la seconde couche d'étanchéité (7.2) pour parfaire le bouchon (6).

**21.** Procédé de réalisation d'un microcomposant encapsulé selon l'une des revendications 14 à 20, dans lequel on prévoit une étape de dépôt, sur le substrat (2), d'une électrode (9.1) par orifice d'un dispositif d'activation du matériau getter, cette électrode avant une extrémité localisée en vis-à-vis de l'orifice (5), destinée à venir en contact électrique avec le matériau getter.

**22.** Procédé de réalisation d'un microcomposant encapsulé selon la revendication 21, dans lequel on prévoit une étape de dépôt d'une autre électrode (9.2) du dispositif d'activation du matériau getter, soit sur le matériau sacrificiel (10), soit sur le matériau d'encapsulation, cette autre électrode devant venir au contact du matériau getter à proximité de l'orifice.

**23.** Procédé de réalisation d'un microcomposant encapsulé selon l'une des revendications 14 à 22, dans lequel on prévoit une étape de dégazage après l'étape d'élimination du matériau sacrificiel et avant l'étape de dépôt du matériau getter.

**Claims**

**1.** Encapsulated microcomponent having a cover (3) coming into contact with a substrate (2), delimiting a sealed cavity (4) equipped with at least one orifice (5) provided with a plug (6), which comprises a portion (6.1) made of a getter material exposed inside of the cavity, **characterized in that** getter material is located on the substrate (2) opposite the orifice (5).

**2.** Microcomponent according to claim 1, **characterised in that** the plug (6) also comprises at least one sealing portion (7) that is superimposed on the getter material portion (6.1).

**3.** Microcomponent according to claim 1, **characterised in that** the getter material of the getter material portion (6.1) has a column structure.

**4.** Microcomponent according to claim 1, **characterised in that** the material of the getter material portion (6.1) has a first column structure area that is extended by a second crystallised structure area (6.2), farther from the cover than the crystallised structure area.

**5.** Microcomponent according to one of claims 1 to 4, **characterised in that** the getter material is chosen from titanium, vanadium, zirconium, barium or mixtures thereof.

**6.** Microcomponent according to one of claims 1 to 5, **characterised in that** the sealing portion (7) is made of a metal material chosen from gold, platinum, chromium, aluminium or mixtures thereof or a dielectric material chosen from silicon nitride or silicon oxide.

**7.** Microcomponent according to one of claims 1 to 6, **characterised in that** the cover (3) comes into contact with a substrate (2) at the level of its getter material portion (6.1).

**8.** Microcomponent according to one of claims 1 to 7, **characterised in that** the cover (3) comprises a portion that delimits an active cavity (40.1) and a portion that delimits a pump channel (40.2) of lower thickness than the active cavity, wherein the active cavity communicates with the pump channel, and the orifice (5) leads to the pump channel and/or to the active portion.

**9.** Microcomponent according to one of claims 1 to 8, **characterised in that** the cover (3) comprises a top wall (4.1) in which the plug (6) is located.

10. Microcomponent according to one of claims 1 to 9, **characterised in that** it comprises an active portion (1) housed in the cavity (4) and supported by a substrate (2) with which the cover (3) comes into contact, in which the getter material portion (6.1) passes through a hole (8) provided in the active portion (1).

11. Microcomponent according to one of claims 1 to 10, **characterised in that** the cover (3) comes into contact with the substrate (2), with one electrode (9.1) of an electrode pair (9.1, 9.2) in a device for activation of the getter material being inserted between the getter material portion (6.1) of the plug (6) and the substrate (2).

12. Microcomponent according to claim 11, **characterised in that** the other electrode (9.2) of the electrode pair of the device for activation of the getter material is borne by the cover (3), with this other electrode (9.2) extending either inside the cavity or outside the cavity (4) and coming into contact with the getter material near the orifice (5).

13. Microcomponent according to claim 12, **characterised in that** the other electrode (9.2) of the electrode pair of the device for activation of the getter material serves as a sealing portion.

14. Method for producing an encapsulated microcomponent, **characterised in that** it comprises steps consisting of:

   - covering, with a sacrificial material (10), a substrate (2) supporting an active portion (1) of the microcomponent, which sacrificial material (10) serves as shape for the microcomponent cover;
   - depositing, on the sacrificial material, an encapsulation material so as to form a cover (3) delimiting a cavity (4);
   - opening one or more orifices (5) in the encapsulation material;
   - removing the sacrificial material through the orifices (5);
   - depositing a getter material on the cover (3) so that it is exposed inside the cavity and totally or partially plugs the orifices (5) and rests on the substrate (2) opposite the orifices (5).

15. Method for producing an encapsulated microcomponent according to claim 14, **characterised in that** the getter material is deposited by vacuum deposition, at least at the beginning, on a surface of which the temperature is between around 0.2 and 0.5 times the melting temperature of the getter material, so as to obtain a column deposit structure of the getter material, with the temperatures being expressed in degrees Kelvin.

16. Method for producing an encapsulated microcomponent according to claim 15, **characterised in that** the getter material is deposited afterward, under the same pressure conditions, but on a surface of which the temperature is greater than around 0.5 times the melting temperature of the getter material so as to obtain a crystallized deposit structure of the getter material.

17. Method for producing an encapsulated microcomponent according to one of claims 14 to 16, **characterised in that** it includes a step of deposition of a first sealing layer (7.1), and optionally a second sealing layer (7.2) on the first sealing layer, wherein the first and the second sealing layers are superimposed on the getter material.

18. Method for producing an encapsulated microcomponent according to claim 17, **characterised in that** the first sealing layer (7.1) is deposited substantially at the same pressure as the deposition of the getter material.

19. Method for producing an encapsulated microcomponent according to one of claims 14 to 18, **characterised in that** it includes a step of etching the getter material as well as the first sealing layer (7.1), if it exists, so as to preserve, at the level of each orifice, only a plug (6).

20. Method for producing an encapsulated microcomponent according to claim 19, **characterised in that** it includes a step of etching the second sealing layer (7.2) in order to complete the plug (6).

21. Method for producing an encapsulated microcomponent according to one of claims 14 to 20, **characterised in that** it includes a step of deposition, on the substrate (2), of an electrode (9.1), for each orifice, of a device for activation of the getter material, which electrode has an end located opposite the orifice (5), intended to come into electrical contact with the getter material.

22. Method for producing an encapsulated microcomponent according to claim 21, **characterised in that** it includes a step of depositing another electrode (9.2) of the device for activation of the getter material, either on the sacrificial material (10), or on the encapsulation material, which other electrode must come into contact with the getter material near the orifice.

23. Method for producing an encapsulated microcomponent according to one of claims 14 to 22, **characterised in that** it includes a degassing step after the step of removing the sacrificial material and before the step of depositing the getter material.


**Patentansprüche**

1. Gekapseltes Mikrobauteil mit einer auf einem Substrat (2) befestigten Abdeckung (3), die einen dichten Hohlraum abgrenzt, der eine Öffnung (5) aufweist, verschlossen durch einen Stopfen (6) mit einem der Innenseite des Hohlraums ausgesetzten Teil (6.1) aus Gettermaterial,
**dadurch gekennzeichnet, dass** sich das Gettermaterial auf dem Substrat (2) befindet, gegenüber der Öffnung (5).

2. Mikrobauteil nach Anspruch 1, bei dem der Stopfen (6) auch wenigstens einen Abdichtungsteil (7) umfasst, der sich über dem Teil (6.1) aus Gettermaterial befindet.

3. Mikrobauteil nach Anspruch 1, bei dem das Gettermaterial des Gettermaterialteils (6.1) eine säulenförmige Struktur hat.

4. Mikrobauteil nach Anspruch 1, bei dem das Material des Gettermaterialteils (6.1) eine erste Zone mit kolumnarer Struktur besitzt, die verlängert wird durch eine zweite Zone (6.2) mit kristalliner Struktur, wobei die Zone mit kolumnarer Strukur von der Abdeckung weiter entfernt ist als die Zone mit kristalliner Struktur.

5. Mikrobauteil nach einem der Ansprüche 1 bis 4, bei dem das Gettermaterial ausgewählt wird unter Titan, Vanadium, Zirkon, Barium oder ihren Mischungen.

6. Mikrobauteil nach einem der Ansprüche 1 bis 5, bei dem der Abdichtungsteil (7) aus einem metallischen Material ist, ausgewählt unter Gold, Platin, Chrom, Aluminium oder ihren Mischungen, oder aus einem dielektrischen Material, ausgewählt zwischen Siliciumnitrid und Siliciumoxid.

7. Mikrobauteil nach einem der Ansprüche 1 bis 6, bei dem der Stopfen (6) mit dem Substrat (2) durch seinen Teil (6.1) aus Gettermaterial Kontakt hat.

8. Mikrobauteil nach einem der Ansprüche 1 bis 7, bei dem die Abdeckung (3) einen Teil umfasst, der einen aktiven Hohlraum (40.1) abgrenzt, und einen Teil, der einen Pumpkanal (40.2) von geringerer Dicke als der aktive Hohlraum abgrenzt, wobei der aktive Hohlraum mit dem Pumpkanal kommuniziert und die Öffnung (5) in den Pumpkanal und/ oder in dem aktiven Teil mündet.

9. Mikrobauteil nach einem der Ansprüche 1 bis 8, bei dem die Abdeckung (3) eine obere Wand (4.1) umfasst, in der sich der Stopfen (6) befindet.

10. Mikrobauteil nach einem der Ansprüche 1 bis 9, mit einem aktiven Teil (1), enthalten in dem Hohlraum (4) und getragen durch ein Substrat (2), auf dem die Abdeckung (3) befestigt ist, deren Teil (6.1) aus Gettermaterial eine Lücke (8) durchquert, mit der der aktive Teil (1) versehen ist.

11. Mikrobauteil nach einem der Ansprüche 1 bis 10, bei dem die Abdeckung (3) auf dem Substrat (2) sitzt, eine Elektrode (9.1) eines Elektrodenpaares (9.1, 9.2) einer Aktivierungseinrichtung des Gettermaterials eingefügt ist zwischen dem Teil (6.1) aus Gettermaterial des Stopfens (6) und dem Substrat (2).

12. Mikrobauteil nach Anspruch 11, bei dem die andere Elektrode (9.2) des Elektrodenpaares der Aktivierungseinrichtung des Gettermaterials durch die Abdeckung (3) getragen wird, wobei diese andere Elektrode (9.2) sich entweder innerhalb des Hohlraums oder außerhalb des Hohlraums (4) erstreckt und in der Nähe der Öffnung (5) mit dem Gettermaterials Kontakt hat.

13. Mikrobauteil nach Anspruch 12, bei dem die andere Elektrode (9.2) des Elektrodenpaars der Aktivierungseinrichtung des Gettermaterials als Abdichtungsteil dient.

**14.** Herstellungsverfahren eines gekapselten Mikrobauteils, die folgenden Schritte umfassend:

- Überziehen eines einen aktiven Teil (1) des Mikrobauteils enthaltenden Substrats (2) mit Opfermaterial, wobei dieses Opfermaterial (10) als Form für die Abdeckung des Mikrobauteils dient;
- Abscheiden eines Kapselungsmaterials auf dem Opfermaterial, um eine einen Hohlraum (4) abgrenzende Abdeckung (3) zu bilden;
- Öffnen einer oder mehrerer Öffnungen (5) in dem Kapselungsmaterial;
- Eliminieren des Opfermaterials durch die Öffnungen (5) hindurch;
- Abscheiden eines Gettermaterials auf der Abdeckung (3), so dass es der Innenseite des Hohlraums ausgesetzt ist, die Öffnungen (5) ganz oder teilweise verschießt und auf dem Substrat (2) ruht, gegenüber den Öffnungen (5).

**15.** Herstellungsverfahren eines gekapselten Mikrobauteils nach Anspruch 14, bei dem die Abscheidung des Gettermaterials durch Vakuumaufdampfung erfolgt - wenigstens zu Beginn - auf eine Oberfläche, deren Temperatur zwischen dem 0,2- und dem 0,5fachen der Schmelztemperatur des Gettermaterials enthalten ist, um eine kolumnare Abscheidungsstruktur des Gettermaterials zu erhalten, wobei die Temperaturen in Grad Kelvin ausgedrückt werden.

**16.** Herstellungsverfahren eines gekapselten Mikrobauteils nach Anspruch 15, bei dem die Abscheidung des Gettermaterials in der Folge unter den gleichen Druckbedingungen aber auf einer Oberfläche erfolgt, deren Temperatur höher ist als das ungefähr 0,5 fache der Schmelztemperatur des Gettermaterials, um eine kristalline Struktur des Gettermaterials zu erhalten.

**17.** Herstellungsverfahren eines gekapselten Mikrobauteils nach einem der Ansprüche 14 bis 16, bei dem man einen Schritt zur Abscheidung einer ersten Abdichtungsschicht (7.1) und eventuell einer zweiten Abdichtungsschicht (7.2) auf der ersten Abdichtungsschicht vorsieht, wobei die erste und die zweite Abdichtungsschicht sich über dem Gettermaterial befinden.

**18.** Herstellungsverfahren eines gekapselten Mikrobauteils nach Anspruch 17, bei dem die Abscheidung der ersten Abdichtungsschicht (7.1) im Wesentlichen mit dem gleichen Druck erfolgt wie die Abscheidung des Gettermaterials.

**19.** Herstellungsverfahren eines gekapselten Mikrobauteils nach einem der Ansprüche 14 bis 18, bei dem man einen Schritt zur Ätzung des Gettermaterials sowie der ersten Abdichtungsschicht (7.1) vorsieht, wenn sie dazu da ist, in Höhe jeder Öffnung nur einen Stopfen (6) zu behalten.

**20.** Herstellungsverfahren eines gekapselten Mikrobauteils nach Anspruch 19, bei dem man einen Schritt zur Ätzung der zweiten Abdichtungsschicht (7.2) vorsieht, um den Stopfen (6) zu vervollkommnen.

**21.** Herstellungsverfahren eines gekapselten Mikrobauteils nach einem der Ansprüche 14 bis 20, bei dem man einen Schritt zur Abscheidung einer Elektrode (9.1) pro Öffnung einer Aktivierungseinrichtung des Gettermaterials auf dem Substrat (2) vorsieht, wobei diese Elektrode ein der Öffnung (5) gegenüber lokalisiertes Ende hat, das der Herstellung des elektrischen Kontakts mit dem Gettermaterial dient.

**22.** Herstellungsverfahren eines gekapselten Mikrobauteils nach Anspruch 21, bei dem man einen Schritt zur Abscheidung einer anderen Elektrode (9.2) der Aktivierungseinrichtung des Gettermaterials vorsieht, entweder auf dem Opfermaterial (10) oder auf dem Kapselungsmaterial, wobei diese andere Elektrode mit dem Gettermaterial in der Nähe der Öffnung in Kontakt kommen soll.

**23.** Herstellungsverfahren eines gekapselten Mikrobauteils nach einem der Ansprüche 14 bis 22, bei dem man einen Entgasungsschritt vorsieht, nach dem Schritt zur Eliminierung des Opfermaterials und vor dem Schritt zur Abscheidung des Gettermaterials.

FIG. 1A

FIG. 1B

FIG. 2A

FIG. 2B

FIG. 3

## FIG. 4A

## FIG. 4B

## FIG. 4C

**FIG. 5A**

**FIG. 5B**

**FIG. 5C**

**FIG. 5D**

## FIG. 5E

## FIG. 5F

## FIG. 5G

## FIG. 5H

**FIG. 5I**

**FIG. 5J**

**FIG. 5K**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2004006290 A
- WO 2004065289 A
- EP 0525764 A
- EP 1101730 A
- US 2005017313 A